# EUROPEAN PATENT APPLICATION

(11) **EP 2 762 996 A2**
(43) Date of publication of application: **06.08.2014**
(21) Application number: 13186096.7
(22) Date of filing: 26.09.2013
(51) Int. Cl.: G06F 3/01

(54) **Display apparatus and method of displaying image using the same**

(30) Priority: 01.02.2013 KR 20130011912
(71) Applicant: Samsung Display Co., Ltd., Yongin-City, Gyeonggi-Do, 446-711 (KR)
(72) Inventor: Lee, Yong-Hui, 446-711 Yongin-City (KR)
(74) Representative: Gulde & Partner

(57) **Abstract**

A display apparatus (100) includes a display (110) configured to display an end portion of an image according to a tapping signal and a tap sensor (130) configured to sense tapping at a peripheral portion (121, 122, 123, 124) around the display (110) and to output the tapping signal to the display (110).

## Description

### CROSS-REFERENCE TO RELATED APPLICATION(S)

This application claims priority to and the benefit of Korean Patent Applications No. 10-2013-0011912, filed on February 1, 2013 in the Korean Intellectual Property Office (KIPO), the content of which is incorporated herein in its entirety by reference.

### BACKGROUND

### 1. Field

Embodiments of the present invention relate generally to a display apparatus and a method of displaying an image. More particularly, embodiments of the present invention relate to a display apparatus capable of sensing a tapping and a method of displaying an image.

### 2. Description of the Related Art

An image, such as a character or a picture, provided through a network (e.g., the internet) may be displayed on a smart phone.

However, a size of the image may be greater than a size of a display part of the smart phone, and thus, a user scrolls several times when the user wants to view the uppermost portion or the lower most portion of the image while viewing the image.

### SUMMARY

Aspects of the present invention provide a display apparatus capable of easily displaying an end portion of an image, and a method of using the display apparatus.

According to one embodiment, a display apparatus includes: a display configured to display an end portion of an image according to a tapping signal; and a tap sensor configured to sense tapping at a peripheral portion of the display and to output the tapping signal to the display when the tapping is sensed.

The tap sensor may include an upper side tapping sensor configured to sense the tapping at an upper side peripheral portion of the display and to output an upper side signal when the tapping is sensed at the upper side peripheral portion.

The display may be configured to display an upper side end portion of the image in response to the upper side signal.

The upper side tapping sensor may include a vibration sensor for sensing the tapping.

The tap sensor may include a lower side tapping sensor configured to sense the tapping at a lower side peripheral portion of the display and to output a lower side signal when the tapping is sensed at the lower side peripheral portion.

The display may be configured to display a lower side end portion of the image in response to the lower side signal.

The lower side tapping sensor may include a vibration sensor for sensing the tapping.

The tap sensor may include a left side tapping sensor configured to sense the tapping at a left side peripheral portion of the display and to output a left side signal when the tapping is sensed at the left side peripheral portion.

The display may be configured to display a left side end portion of the image in response to the left side signal.

The left side tapping sensor may include a vibration sensor for sensing the tapping.

The tap sensor may include a right side tapping sensor configured to sense the tapping at a right side peripheral portion of the display and to output a right side signal when the tapping is sensed at the right side peripheral portion.

The display may be configured to display a right side end portion of the image in response to the right side signal.

The right side tapping sensor may include a vibration sensor for sensing the tapping.

The tap sensor may be configured to output the tapping signal when the tap sensor senses the tapping including two taps.

The tap sensor may include a vibration sensor for sensing the tapping.

The display apparatus may be a liquid crystal display apparatus including a liquid crystal.

The display apparatus may be an organic light emitting diode display apparatus including an organic light emitting diode.

The side tapping sensors may comprise the same size. Alternatively, a number of tap sensing parts may have a bigger surface or area, for example to take account for preferred wishes of the user like when for example the upper and/or lower end portion of the image is viewed most. The side tapping sensors can be arranged directly adjacent to each other. Further, two side tapping sensors may be activated at the same time for example the upper side tapping sensor and the right side tapping sensor. Accordingly, the signals UPS and RIS are outputted and the upper right corner of the image is displayed according to the two tapping signals.

According to one embodiment, a method of displaying an image includes: sensing tapping; outputting a tapping signal when the tapping is sensed; and displaying an end portion of the image on a display according to the tapping signal.

The tapping may be sensed at a peripheral portion around the display.

Outputting the tapping signal may include outputting an upper side signal when the tapping is sensed at an upper side peripheral portion of the display.

Displaying the end portion of the image may include displaying an upper side end portion of the image in response to the upper side signal.

Outputting the tapping signal may include outputting a lower side signal when the tapping is sensed at a lower side peripheral portion of the display.

Displaying the end portion of the image may include displaying a lower side end portion of the image in response to the lower side signal.

Outputting the tapping signal may include outputting a left side signal when the tapping is sensed at a left side peripheral portion of the display.

Displaying the end portion of the image may include displaying a left side end portion of the image in response to the left side signal.

Outputting the tapping signal may include outputting a right side signal when the tapping is sensed at a right side peripheral portion of the display.

Displaying the end portion of the image may include displaying a right side end portion of the image in response to the right side signal.

Outputting the tapping signal may include outputting the tapping signal when the tapping includes two taps.

Therefore, a display apparatus and a method of displaying an image using the display apparatus according to example embodiments may sense a tapping of a user applied to an upper side peripheral portion, a lower side peripheral portion, a left side peripheral portion and a right side peripheral portion around a display to output a tapping signal, and the display displays the uppermost portion, the lowest portion, the leftmost portion, and the rightmost portion of an image in response to the tapping signal. Thus, the user may easily change the view to display the uppermost portion, the lowest portion, the leftmost portion, and the rightmost portion of the image without scrolling (e.g., scrolling several times) when viewing another portion of the image.

### BRIEF DESCRIPTION OF THE DRAWINGS

Illustrative, non-limiting example embodiments will be more clearly understood from the following detailed description taken in conjunction with the accompanying drawings.

FIG. 1 is a block diagram illustrating a display apparatus according to an example embodiment of the present invention.

FIGS. 2A, 2B, 2C and 2D are plan views illustrating the display apparatus of FIG. 1.

FIGS. 3A, 3B and 3C are flow charts illustrating a method of displaying an image using the display apparatus in FIGS. 1, 2A, 2B, 2C and 2D.

### DETAILED DESCRIPTION

Various example embodiments will be described more fully hereinafter with reference to the accompanying drawings, in which some example embodiments are shown. The present inventive concept may, however, be embodied in many different forms and should not be construed as limited to the example embodiments set forth herein. Rather, these example embodiments are provided so that this disclosure will be thorough and complete, and will fully convey the scope of the present inventive concept to those skilled in the art. In the drawings, the sizes and relative sizes of layers and regions may be exaggerated for clarity. Like numerals refer to like elements throughout.

It will be understood that, although the terms first, second, third, etc. may be used herein to describe various elements, these elements should not be limited by these terms. These terms are used to distinguish one element from another. Thus, a first element discussed below could be termed a second element without departing from the teachings of the present inventive concept. As used herein, the term "and/or" includes any and all combinations of one or more of the associated listed items.

It will be understood that when an element is referred to as being "connected" or "coupled" to another element, it can be directly connected or coupled to the other element or one or more intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular example embodiments only and is not intended to be limiting of the present inventive concept. As used herein, the singular forms "a," "an" and "the" are intended to include the plural forms as well, unless the context clearly indicates otherwise. It will be further understood that the terms "includes", "including", "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

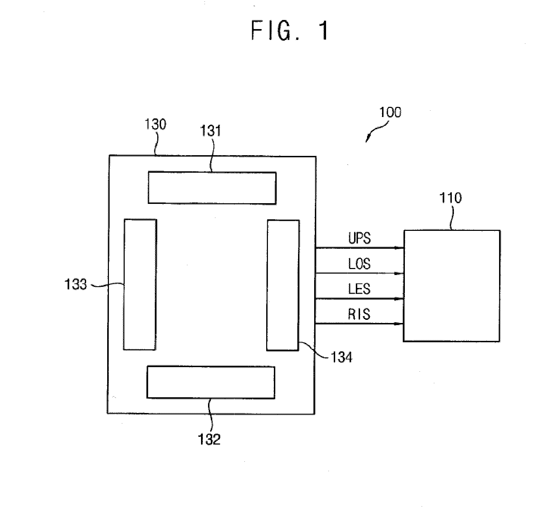

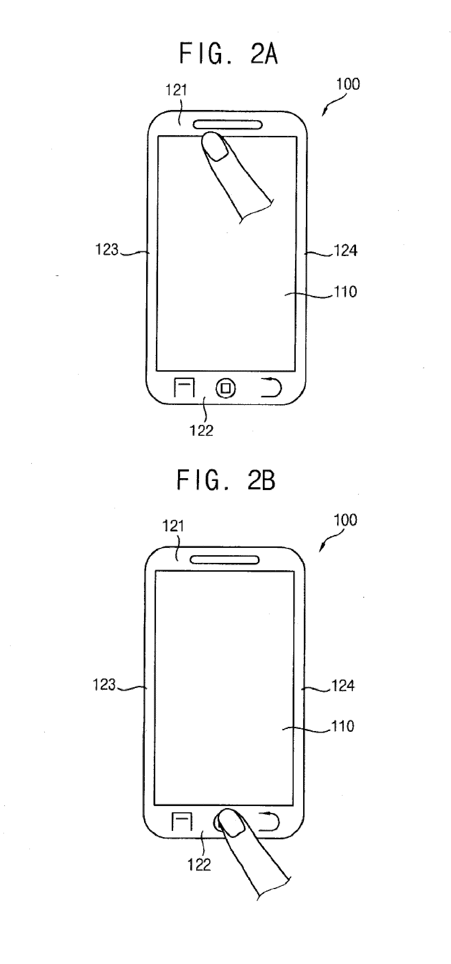

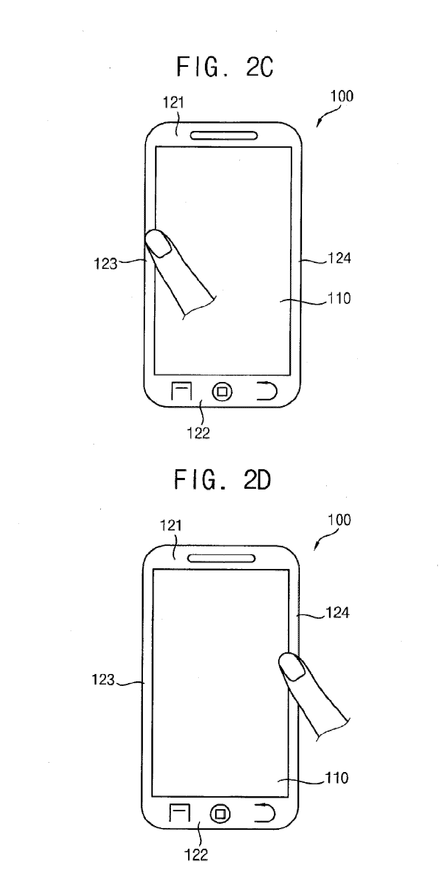

FIG. 1 is a block diagram illustrating a display apparatus according to an example embodiment of the present invention, and FIGS. 2A, 2B, 2C and 2D are plan views illustrating the display apparatus of FIG. 1.

Referring to FIGS. 1, 2A, 2B, 2C and 2D, the display apparatus 100 includes a display part 110 (or display) and a tap sensing part 130 (or tap sensor). The display apparatus 100 may be a liquid crystal display (LCD) apparatus including a liquid crystal. Alternatively, the display apparatus 100 may be an organic light emitting diode (OLED) display apparatus including an organic light emitting diode (OLED). For example, the display apparatus 100 may be included in a smart phone or a tablet PC.

The display part 110 displays an image. The image includes at least one of a character, a picture, or a moving picture. When the display apparatus 100 is included in a smart phone or a tablet PC, the display part 110 may display a portion of the image. For example, a size of the picture may be greater than a size of the display part 110, and in this case, the display part 110 may display the portion of the image.

The display part 110 displays an end portion of the image according to a tapping signal received from the tap sensing part 130. For example, the display part 110 may display the uppermost portion of the image according to (e.g., in response to) the tapping signal when displaying a middle portion of the image. In addition, the display part 110 may display the lowest portion of the image according to (e.g., in response to) the tapping signal when displaying the middle portion of the image, the display part 110 may display the leftmost portion of the image according to (e.g., in response to) the tapping signal when displaying the middle portion of the image, or the display part 110 may display the rightmost portion of the image according to (e.g., in response to) the tapping signal when displaying the middle portion of the image.

The tap sensing part 130, according to the present embodiment, includes an upper side tap sensing part 131, a lower side tap sensing part 132, a left side tap sensing part 133, and a right side tap sensing part 134.

The upper side tap sensing part 131 senses tapping at an upper side peripheral portion 121 at (e.g., disposed at or located at) an upper side of the display part 110. For example, as illustrated in FIG. 2A, when the upper side peripheral portion 121 is tapped by a finger of a user, the upper side tap sensing part 131 senses the tapping and outputs an upper side signal UPS to the display part 110. The upper side tap sensing part 131 may output the upper side signal UPS after sensing two taps generated in a suitable time (e.g., a preset or predetermined time) so as to prevent outputting the upper side signal UPS caused by a tapping owing to a mistake of the user (e.g., accidental or unintentional taps). According to one embodiment, the upper side tap sensing part 131 may include a vibration sensor for sensing the tapping.

The display part 110 displays an upper side end portion of the image in response to the upper side signal UPS outputted from the upper side tap sensing part 131 of the tap sensing part 130. For example, the display part 110 displays the uppermost portion of the image in response to the upper side signal UPS. The uppermost portion of the image may include a menu, an internet address and so on. According to an aspect of the inventive concept, the user may adjust the view to display the uppermost portion of the image without scrolling (e.g., scrolling several times) when viewing (e.g. initially viewing) another portion (e.g., the middle portion) of the image.

The lower side tap sensing part 132 senses the tapping at a lower side peripheral portion 122 at (e.g., disposed at or located at) a lower side of the display part 110. For example, as illustrated in FIG. 2B, when the lower side peripheral portion 122 is tapped by the finger of the user, the lower side tap sensing part 132 senses the tapping and outputs a lower side signal LOS to the display part 110. The lower side tap sensing part 132 may output the lower side signal LOS after sensing two taps generated in a suitable (e.g., set or predetermined) time so as to prevent outputting the lower side signal LOS caused by a tapping owing to a mistake of the user. According to one embodiment, the lower side tap sensing part 132 may include a vibration sensor for sensing the tapping.

The display part 110 displays a lower side end portion of the image in response to the lower side signal LOS outputted from the lower side tap sensing part 132 of the tap sensing part 130. For example, the display part 110 displays the lowest portion of the image in response to the lower side signal LOS. The lowest portion of the image may include a comment, a recommendation button, and so on. According to an aspect of the inventive concept, the user may adjust the view to display the lowest portion of the image without scrolling (e.g. scrolling several times) when viewing (e.g., initially viewing) another portion (e.g., the middle portion) of the image.

The left side tap sensing part 133 senses the tapping at a left side peripheral portion 123 at (e.g., located at or disposed at) a left side of the display part 110. For example, as illustrated in FIG. 2C, when the left side peripheral portion 123 is tapped by the finger of the user, the left side tap sensing part 133 senses the tapping and outputs a left side signal LES to the display part 110. The left side tap sensing part 133 may output the left side signal LES after sensing two taps generated in a suitable (e.g., a set or predetermined) time so as to prevent outputting the left side signal LES caused by a tapping owing to a mistake of the user. According to one embodiment, the left side tap sensing part 133 may include a vibration sensor for sensing the tapping.

The display part 110 displays a left side end portion of the image in response to the left side signal LES outputted from the left side tap sensing part 133 of the tap sensing part 130. For example, the display part 110 displays the leftmost portion of the image in response to the left side signal LES. The leftmost portion of the image may display the front most portion of a menu, a picture, or an album of music spread in a horizontal direction. According to an aspect of the inventive concept, the user may adjust the view to display the leftmost portion of the image without scrolling (e.g., scrolling several times) when viewing (e.g. initially viewing) another portion (e.g., the middle portion) of the image.

The right side tap sensing part 134 senses the tapping at a right side peripheral portion 124 at (e.g., located at or disposed at) a right side of the display part 110. For example, as illustrated in FIG. 2D, when the right side peripheral portion 124 is tapped by the finger of the user, the right side tap sensing part 134 senses the tapping and outputs a right side signal RIS to the display part 110. The right side tap sensing part 134 may output the right side signal RIS after sensing two taps generated in a suitable (e.g., a set or predetermined) time so as to prevent outputting the right side signal RIS caused by a tapping owing to a mistake of the user. According to one embodiment, the right side tap sensing part 134 may include a vibration sensor for sensing the tapping.

The display part 110 displays a right side end portion of the image in response to the right side signal RIS outputted from the right side tap sensing part 134 of the tap sensing part 130. For example, the display part 110 displays the rightmost portion of the image in response to the right side signal RIS. The rightmost portion of the image may display the rearmost portion of a menu, a picture, or an album of music spread in a horizontal direction. According to an aspect of the inventive concept, the user may change the view to display the rightmost portion of the image without scrolling (e.g., scrolling several times) when viewing (e.g., initially viewing) another portion (e.g., the middle portion) of the image.

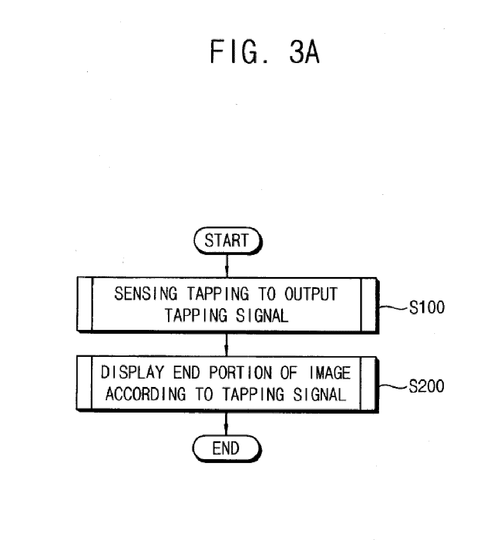

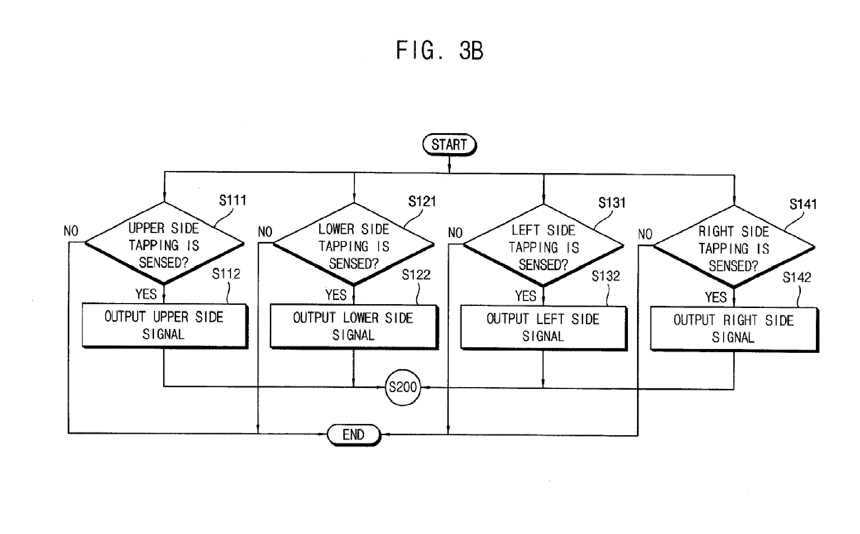

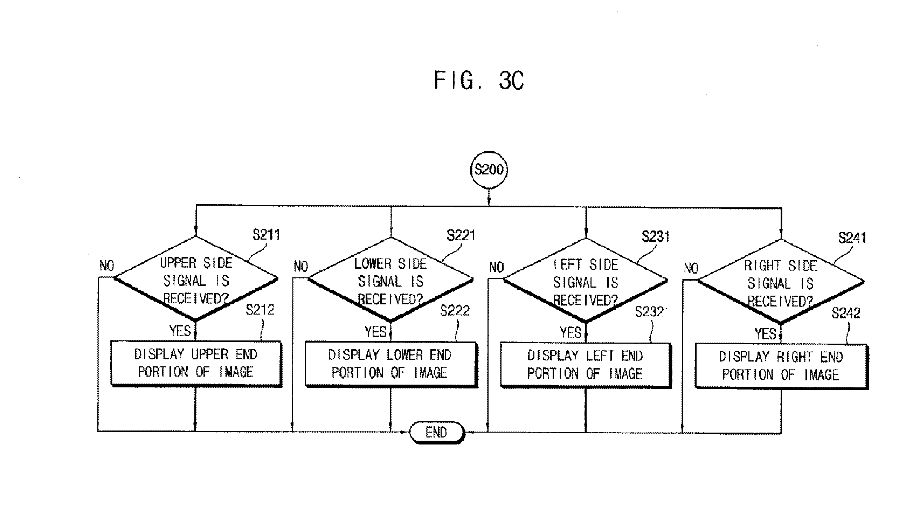

FIGS. 3A, 3B and 3C are flow charts illustrating a method of displaying an image using the display apparatus 100 in FIGS. 1, 2A, 2B, 2C and 2D.

Referring to FIGS. 1, 2A, 2B, 2C, 2D, 3A, 3B and 3C, the tap sensing part 130 senses the tapping to output the tapping signal (S100).

For example, when the upper side peripheral portion 121 is tapped by the finger of the user, the upper side tap sensing part 131 of the tap sensing part 130 determines whether or not the upper side peripheral portion 121 is tapped (S111). When the upper side tap sensing part 131 determines that the upper side peripheral portion 121 is tapped, the tap sensing part 130 outputs the upper side signal UPS (S112). The upper side tap sensing part 131 may include the vibration sensor for sensing the tapping, and the upper side tap sensing part 131 may output the upper side signal UPS after sensing the two taps generated in the predetermined time so as to prevent outputting the upper side signal UPS caused by the tapping owing to the mistake of the user.

In addition, when the lower side peripheral portion 122 is tapped by the finger of the user, the lower side tap sensing part 132 of the tap sensing part 130 determines whether or not the lower side peripheral portion 122 is tapped (S121). When the lower side tap sensing part 132 determines that the lower side peripheral portion 122 is tapped, the tap sensing part 130 outputs the lower side signal LOS (S122). The lower side tap sensing part 132 may include the vibration sensor for sensing the tapping, and the lower side tap sensing part 132 may output the lower side signal LOS after sensing the two taps generated in the predetermined time so as to prevent outputting the lower side signal LOS caused by the tapping owing to the mistake of the user.

In addition, when the left side peripheral portion 123 is tapped by the finger of the user, the left side tap sensing part 133 of the tap sensing part 130 determines whether or not the left side peripheral portion 123 is tapped (S131). When the left side tap sensing part 133 determines that the left side peripheral portion 123 is tapped, the tap sensing part 130 outputs the left side signal LES (S132). The left side tap sensing part 133 may include the vibration sensor for sensing the tapping, and the left side tap sensing part 133 may output the left side signal LES after sensing the two taps generated in the predetermined time so as to prevent outputting the left side signal LES caused by the tapping owing to the mistake of the user.

In addition, when the right side peripheral portion 124 is tapped by the finger of the user, the right side tap sensing part 134 of the tap sensing part 130 determines whether or not the right side peripheral portion 124 is tapped (S141). When the right side tap sensing part 134 determines that the right side peripheral portion 124 is tapped, the tap sensing part 130 outputs the right side signal RIS (S142). The right side tap sensing part 134 may include the vibration sensor for sensing the tapping, and the right side tap sensing part 134 may output the right side signal RIS after sensing the two taps generated in the determined time so as to prevent outputting the right side signal RIS caused by the tapping owing to the mistake of the user.

The display part 110 displays an end portion of the image according to the tapping signal outputted from the tap sensing part 130 (S200).

For example, the display part 110 determines whether the upper side signal UPS is received from the tap sensing part 130 (S211). When the display part 110 receives the upper side signal UPS from the tap sensing part 130, the display part 110 displays the upper side end portion of the image (S212). For example, the display part 110 displays the uppermost portion of the image in response to the upper side signal UPS. Thus, according to one embodiment, the user may easily change the view to display the uppermost portion of the image without scrolling when viewing (e.g., initially viewing) another portion (e.g., the middle portion) of the image.

In addition, the display part 110 determines whether the lower side signal LOS is received from the tap sensing part 130 (S221). When the display part 110 receives the lower side signal LOS from the tap sensing part 130, the display part 110 displays the lower side end portion of the image (S222). For example, the display part 110 displays the lowest portion of the image in response to the lower side signal LOS. Thus, according to one embodiment, the user may easily change the view to display the lowest portion of the image without scrolling when viewing (e.g., initially viewing) the middle portion of the image.

In addition, the display part 110 determines whether the left side signal LES is received from the tap sensing part 130 (S231). When the display part 110 receives the left side signal LES from the tap sensing part 130, the display part 110 displays the left side end portion of the image (S232). For example, the display part 110 displays the leftmost portion of the image in response to the left side signal LES. Thus, according to one embodiment, the user may easily change the view to display the leftmost portion of the image without scrolling when viewing (e.g., initially viewing) another portion (e.g., the middle portion) of the image.

In addition, the display part 110 determines whether the right side signal RIS is received from the tap sensing part 130 (S241). When the display part 110 receives the right side signal RIS from the tap sensing part 130, the display part 110 displays the right side end portion of the image (S242). For example, the display part 110 displays the rightmost portion of the image in response to the right side signal RIS. Thus, according to one embodiment, the user may simply watch the rightmost portion of the image without the several scrolling during watching the middle portion of the image.

According to the present example embodiments, the tap sensing part 130 senses the tapping of the user applied to the uppers side peripheral portion 121, the lower side peripheral portion 122, the left side peripheral portion 123 and the right side peripheral portion 124 disposed around the display part 110 to output the tapping signal, and the display part 110 displays the uppermost portion, the lowest portion, the leftmost portion and the rightmost portion of the image in response to the tapping signal. Thus, the user may easily change the view to display the uppermost portion, the lowest portion, the leftmost portion and the rightmost portion without the scrolling when viewing another portion of the image.

The present inventive concept may be applied to an electric device having a display apparatus. For example, the present inventive concept may be applied to a laptop, a digital camera, a cellular phone, a smart phone, a personal digital assistant (PDA), a portable multimedia player (PMP), a navigation system, a video phone, etc.

The foregoing is illustrative of example embodiments and is not to be construed as limiting thereof. Although a few example embodiments have been described, those skilled in the art will readily appreciate that many modifications are possible in the example embodiments without materially departing from the features and aspects of the present inventive concept. Accordingly, all such modifications are intended to be included within the scope of the present inventive concept as defined in the claims.

## Claims

1. A display apparatus (100) comprising:
a display (110) configured to display an end portion of an image according to a tapping signal; and
a tap sensor (130) configured to sense tapping at a peripheral portion (121, 122, 123, 124) of the display (110) and to output the tapping signal to the display (110) when the tapping is sensed.

2. The display apparatus of claim 1, wherein the tap sensor (130) comprises an upper side tapping sensor (131) configured to sense the tapping at an upper side peripheral portion (121) of the display (110) and to output an upper side signal when the tapping is sensed at the upper side peripheral portion (121), a lower side tapping sensor (132) configured to sense the tapping at a lower side peripheral portion (122) of the display (110) and to output a lower side signal when the tapping is sensed at the lower side peripheral portion (122), a left side tapping sensor (133) configured to sense the tapping at a left side peripheral portion (123) of the display (110) and to output a left side signal when the tapping is sensed at the left side peripheral portion (123) and/or a right side tapping sensor (134) configured to sense the tapping at a right side peripheral portion (124) of the display (110) and to output a right side signal when the tapping is sensed at the right side peripheral portion (124).

3. The display apparatus of claim 2, wherein the display (110) is configured to display an upper side end portion of the image in response to the upper side signal, is configured to display a lower side end portion of the image in response to the lower side signal, is configured to display a left side end portion of the image in response to the left side signal and is configured to display a right side end portion of the image in response to the right side signal.

4. The display apparatus of one of the preceeding claims, wherein the tap sensor (130) comprises a vibration sensor for sensing the tapping, wherein the upper side tapping sensor (131) comprises a vibration sensor for sensing the tapping, wherein the lower side tapping sensor (132) comprises a vibration sensor for sensing the tapping, wherein the left side tapping sensor (133) comprises a vibration sensor for sensing the tapping and/or wherein the right side tapping sensor (134) comprises a vibration sensor for sensing the tapping.

5. The display apparatus of one of the preceeding claims, wherein the tap sensor (130) is configured to output the tapping signal when the tap sensor (130) senses the tapping comprising two taps.

6. The display apparatus of one of the preceeding claims, wherein the display apparatus is a liquid crystal display apparatus comprising a liquid crystal and/or wherein the display apparatus is an organic light emitting diode display apparatus comprising an organic light emitting diode.

7. A method of displaying an image, the method comprising:
sensing tapping (S100, S111, S121, S131, S141);
outputting a tapping signal when the tapping is sensed (S112, S122, S132, S142, S141); and
displaying an end portion of the image on a display according to the tapping signal (S200, S212, S222, S232, S242).

8. The method of claim 7, wherein the tapping is sensed at a peripheral portion (121, 122, 123, 124) around the display (110).

9. The method of claim 7 or 8, wherein outputting the tapping signal comprises outputting an upper side signal (S112) when the tapping is sensed at an upper side peripheral portion (121) of the display (110), outputting a lower side signal (S122) when the tapping is sensed at a lower side peripheral portion (122) of the display (110), outputting a left side signal (S132) when the tapping is sensed at a left side peripheral portion (123) of the display (110), and/or outputting a right side signal (S142) when the tapping is sensed at a right side peripheral portion (124) of the display (110).

10. The method of one of the preceeding claims, wherein displaying the end portion of the image (S200) comprises displaying an upper side end portion of the image in response to the upper side signal (S212), displaying a lower side end portion of the image in response to the lower side signal (S222), displaying a left side end portion of the image in response to the left side signal (S232) and/or displaying a right side end portion of the image in response to the right side signal (S242).

11. The method of one of the preceeding claims, wherein outputting the tapping signal (S112, S122, S132, S142, S141) comprises outputting the tapping signal when the tapping comprises two taps.
